# NEUE EUROPÄISCHE PATENTSCHRIFT

(11) **EP 0 685 051 B2**
(45) Veröffentlichungstag und Bekanntmachung des Hinweises auf die Entscheidung über den Einspruch: **15.12.1999**
(45) Hinweis auf die Patenterteilung: 27.11.1996
(21) Anmeldenummer: 94906903.3
(22) Anmeldetag: 05.02.1994
(51) Int. Cl.: F16K 27/04, E03C 1/04

(54) **GRUNDKÖRPER FÜR SANITÄRE ARMATUREN**
BASE BODY FOR SANITARY FITTINGS
CORPS DE BASE POUR ROBINETTERIE SANITAIRE

(30) Priorität: 16.02.1993 AT 28793
(43) Veröffentlichungstag der Anmeldung: 06.12.1995
(73) Patentinhaber: Ideal-Standard GmbH & Co. OHG, 53121 Bonn (DE)
(72) Erfinder: MÖNCH, Heiner, D-54344 Kenn (DE)
(74) Vertreter: Puchberger, Rolf, Dipl. Ing.
(86) Internationale Anmeldenummer: EP9400325
(87) Internationale Veröffentlichungsnummer: WO9419633

(56) Entgegenhaltungen:
- EP-A- 0 569 910
- EP-A- 0 572 937
- EP-A- 0 572 939
- CH-A- 670 687
- DE-U- 8 709 865
- DE-U- 9 101 627
- DE-U- 9 112 021

## Beschreibung

Die Erfindung betrifft einen Grundkörper für sanitäre Armaturen, der zur Anpassung an eine ausgewählte Kartusche mit einem Deckel mit Wasserdurchlaßkanälen verbunden ist, deren Enden auf der der Kartusche zugewandten Seite des Deckels in Größe und Form den Wasserein- und Wasserausgängen der Kartusche entsprechen.

Sanitäre Armaturen bestehen aus einem Grundkörper, der als Unterputzkörper oder als Aufputzkörper ausgebildet sein kann, einer Kartusche, die auf dem Grundkörper montiert wird, und einem Gehäuse, sowie einem oder mehreren Bedienungsgriffen, die mit der Kartusche in Eingriff stehen und unter Umständen auch das Gehäuse in seiner Position sichern.

Je nach den Funktionsanforderungen und dem gewünschten äußeren Erscheinungsbild sind die Kartusche, das Gehäuse und die Bedienunggriffe verschieden ausgebildet. Da die Oberfläche des Grundkörpers mit ihren Wasserdurchlaßöffnungen der aufliegenden Fläche der Kartusche entsprechen muß, erforderte bisher jede einzelne Ausführungsform der Kartusche eine entsprechende Ausführungsform des Grundkörpers.

Diese genaue Zuordnung des Grundkörpers zur Kartusche in einer bestimmten sanitären Armatur hat mehrere Nachteile. Der Hersteller muß mehrere Arten von Grundkörpern produzieren und ebenso wie der Händler und der Installateur eine gewisse Anzahl jedes Grundkörpers, z.B. für Reparaturen, auf Lager halten. Will ein Käufer die Kartusche, gegebenfalls mit Gehäuse und Bedienungsgriff, gegen ein anderes Modell austauschen, so muß auch der Grundkörper ausgetauscht werden, selbst wenn dieser noch voll funktionsfähig ist. Insbesondere bei Unterputzkörpern bedeutet dies nicht nur einen finanzell unnötigen Aufwand, sondern auch, daß Stemmarbeiten notwendig sind. Weiters sind beim Bau oder der Renovierung eines Gebäudes die Wasserinstallationsarbeiten zu einem relativ frühen Zeitpunkt vorzunehmen. Mit dem Einbau eines Unterputzkörpers gemäß dem Stand der Technik müßte zu diesem Zeitpunkt bereits die innenarchitektonische Frage der Auswahl der gesamten Armatur getroffen werden.

Die DE-U 9 112 021 beschreibt eine Wasserauslaufarmatur, bei der in einen Hauptkörper ein austauschbarer Kolben eingesetzt wird, dessen Wasseraustrittsöffnungen in eine Mischbatterie münden. Ein schadhafter Kolben kann einfach ausgetauscht werden und durch Austausch des Kolbens kann eine andere Mischbatterie angeschlossen werden. Oft besteht aber auch der Wunsch, mit einer neuen Kartusche auch neue oder mehr Funktionen bei der Armatur zu erhalten.

Aufgabe der Erfindung ist es daher, einen Aufbau für sanitäre Armaturen zu finden, der es ermöglicht, für verschiedene Kartuschen den gleichen Grundkörper zu verwenden, wobei auch Kartuschen mit verschiedenen Funktionen mit dem vorhandenen Grundkörper kombiniert werden können.

Die Aufgabe wird durch die Merkmale des Anspruchs 1 gelöst. In dem so entstandenen Zwischenraum kann z.B. ein Schalldämpfer oder auch eine Umschaltvorrichtung zwischen zwei Wasserausläufen untergebracht werden, wobei auch die Verbindungsteile der Funktion entsprechend ausgebildet werden können.

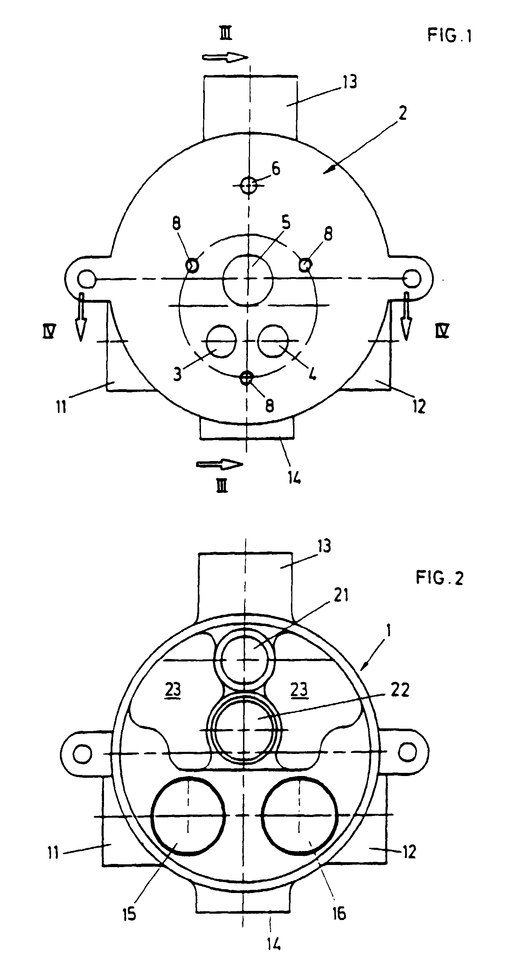

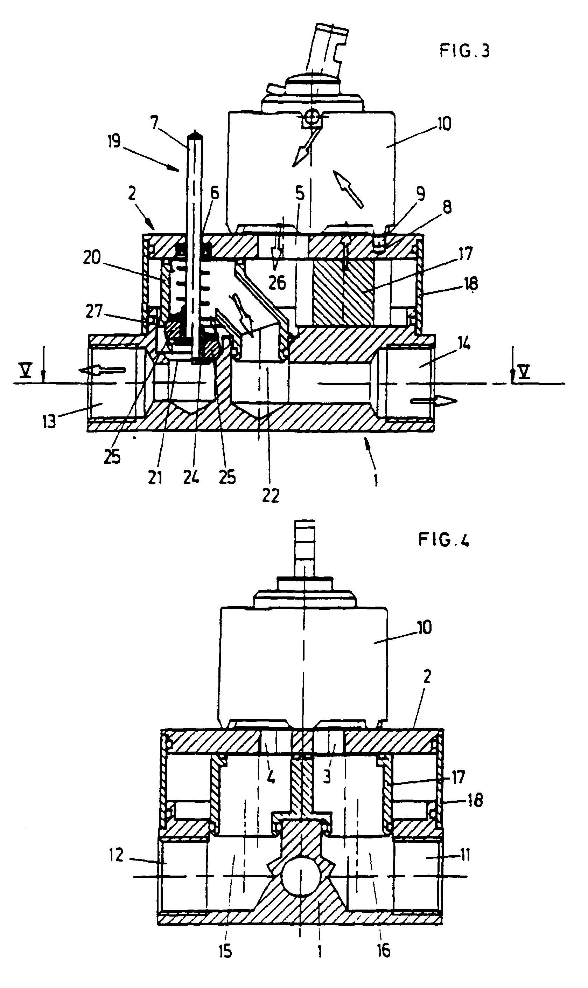

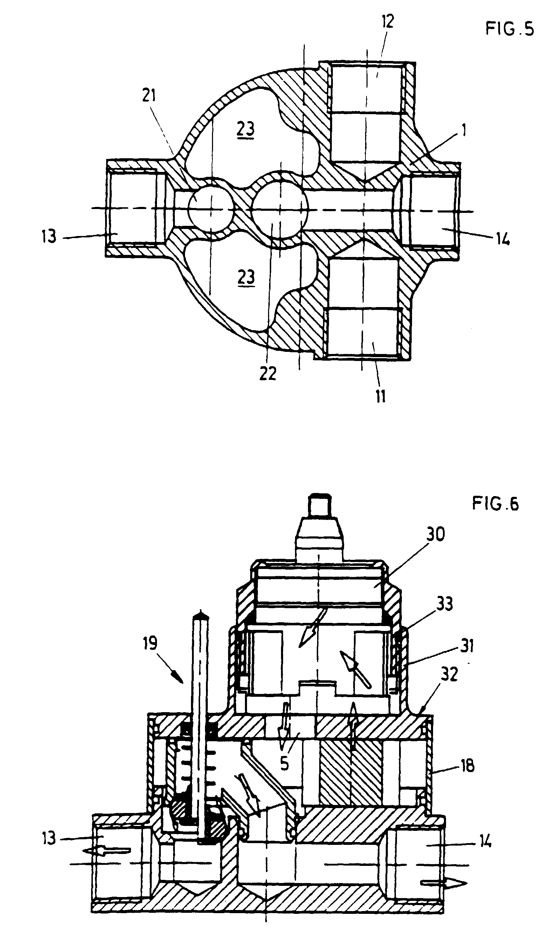

Die Erfindung soll nun anhand von in den beiliegenden Zeichnungen dargestellten Ausführungsbeispielen näher beschrieben werden. Dabei zeigt die Fig.1 eine Draufsicht auf einen Grundkörper mit aufgesetztem Deckel und die Fig.2 eine Draufsicht auf den Grundkörper ohne Deckel. Fig.3 zeigt einen Schnitt durch den Grundkörper gemäß der Linie III-III in Fig.1 und mit aufgesetzter Kartusche. Fig.4 zeigt einen Schnitt durch den Grundkörper gemäß der Linie IV-IV in Fig. 1 mit aufgesetzter Kartusche. Fig.5 zeigt einen Schnitt durch den Grunkörper gemäß der Linie V-V in Fig.3. In Fig.6 ist ein Längsschnitt durch den Grundkörper mit einer anderen Ausformung des Dekkels entsprechend einer anderen Kartusche dargestellt.

Beide Ausführungsformen stellen eine Badearmatur mit Umschaltmöglichkeit zwischen Wanne und Brause dar.

Der in Fig.2 gezeigte Grundkörper 1 wird mit dem Deckel 2 gemäß Fig.1 über einen Distanzring 18 und mehrere Verbindungsteile 17, 20 wie in Fig.3 und 4 dargestellt verbunden. Der Deckel. 2 enthält Warm- und Kaltwasserdurchlässe 3, 4, und einen Mischwasserdurchlaß 5. Ferner sind eine Bohrung 6 für die Zugstange 7 der Wasserwegeumschaltung 19 sowie Sackbohrungen 8, in die entsprechende Zapfen oder Schrauben 9 der Kartusche 10 eingreifen, vorgesehen.

Der Grundkörper 1 weist je ein Warm- und Kaltwasseranschlußstück 11, 12 auf, die in Bohrungen 15, 16 münden und einen Brauseausgangskanal 13, der eine Eingangsöffnung 21 hat, sowie einen Wannenausgangskanal 14, der eine Eingangsöffnung 22 hat. Weiters sind Mischwasserkammern 23 vorgesehen.

In Fig.3 sieht man die Wasserwegeumschaltung 19 mit einer Zugstange 7, die an ihrem unteren Ende einen Formteil 24 mit einem O-Ring 25 trägt. Die linke Seite der Wasserwegeumschaltung 19 ist in Brausestellung, die rechte Seite in Wannenstellung gezeichnet. Zwischen Deckel 2 und Grundkörper 1 sind der Distanzring 18, und die Verbindungsteile 17 und 20 angeordnet.

In den Figuren 3 und 4 ist der Wasserweg ersichtlich. Von den Warm- und Kaltwasseranschlüssen 11, 12 werden Warm- und Kaltwasser über Bohrungen 15, 16 und das Verbindungsstück 17 durch die Durchlässe 3 und 4 im Deckel 2 der Kartusche 10 zugeführt. Das an der Unterseite der Kartusche 10 austretende Mischwasser wird durch den Mischwasserdurchlaß 5 im Deckel 2 in den Innenraum 26 des Distanzringes 18 und in die Kammern 23 im Grundkörper 1 gebracht, wobei es die Verbindungsteile 17 und 20 umfließt Dann tritt das Mischwasser entlang der kreisförmigen Öffnung 27 zwischen dem Verbindungteil 20 und dem Grundkörper 1 hindurch und fließt je nach Stellung der Wasserwegeumschaltung 19 in die Öffnung 21 des Brauseausgangskanals 13 oder über den Verbindungsteil 20 in die Öffnung 22 des Wannenausgangskanals 14.

Fig.6 zeigt den selben Grundkörper wie in den Figuren 1 bis 5, jedoch in Verbindung mit einer anderen Kartusche 30. Bei der dargestellten Kartusche 30 handelt es sich um eine offene Kartusche, deren Mischwasseraustritt seitlich angeordnet ist. Der Deckel 32 ist entsprechend mit einem hülsenförmigen Aufsatz 31 ausgebildet, der gegen die Kartusche 30 mit der Dichtung 33 abgedichtet ist. Das Mischwasser fließt somit in den Raum zwischen Kartusche 30 und Aufsatz 31 des Dekkels 32 und wird dem Mischdurchlaß 5 im Deckel 32 zugeleitet, von wo es dem bereits oben beschriebenen Wasserweg im Grundkörper folgt.

Selbstverständlich kann der selbe Grundkörper auch nur für reine Brausebatterie oder nur für eine reine Wannenbatterie verwendet werden, indem die Öffnung 22 des Wannenausgangkanals 14 oder die Öffnung 21 des Brauseausgangkanals 13 mittels eines entsprechenden Kunststoffformteils verschlossen wird. Die Wasserwegeumschaltung 19 entfällt dann natürlich auch.

Es ist offensichtlich, daß der Grundkörper auch anders ausgestaltet sein kann und daß jede beliebige Kartusche durch Anpassung mittels eines entsprechenden Deckels mit jedem Grundkörper verwendet werden kann.

## Patentansprüche

1. Grundkörper (1) für sanitäre Armaturen, des zur Anpassung an eine ausgewählte Kartusche (10, 30) mit einem Deckel (2, 32) mit Wasserdurchlaßkanälen (3,4,5) verbunden ist, deren Enden auf der der Kartusche (10, 30) zugewandten Seite des Deckels (2, 32) in Größe und Form den Wasser- ein- und Wasserausgängen der Kartusche (10, 30) entsprechen, dadurch gekennzeichnet, daß zwischen Grundkörper (1) und Deckel (2,32) ein Distanzring (18) und Verbindungsteile (17, 20) zur Verbindung der Wasserein- und Wasserausgänge (15, 16, 21, 22) im Grundkörper (1) mit den Wasserdurchlaßkanälen (3, 4, 5) im Deckel (2, 32) vorgesehen sind, wobei der Grundkörper (1), der Distanzring (18), die Verbindungselemente (17, 20) und der Deckel (2, 32) getrennte Teile sind.

2. Grundkörper (1) nach Anspruch 1, dadurch gekennzeichnet daß der Deckel (32) an seiner von Grundkörper (1) abgewandten Seite einen hülsenförmigen Aufsatz (31) mit einer Abdichtung (33) gegen die Kartusche (30) trägt.

## Claims

1. Base body (1) for sanitary fittings, which for adaptation to a selected cartridge (10, 30) is connected to a cover (2, 32) with water through-flow passages (3, 4, 5), the ends of which on the side of the cover (2, 32) which faces the cartridge (10, 30) correspond in size and shape to the water inlets and water outlets of the cartridge (10, 30), characterized in that provided between the base body (1) and the cover (2, 32) are a spacer ring (18) and connecting portions (17, 20) for connecting the water inlets and water outlets (15, 16, 21, 22) in the base body (1) to the water through-flow passages (3, 4, 5) in the cover (2, 32), with the base body (1), the spacer ring (18), the connecting elements (17, 20) and the cover (2, 32) being separate parts.

2. Base body (1) according to claim 1,
characterized in that at its side which faces away from the base body (1) the cover (32) carries a sleeve-shaped attachment (31) with a seal (33) relative to the cartridge (30).

## Revendications

1. Corps de base (1) pour robinetteries sanitaires, qui est relié, pour l'adaptation à une cartouche (10, 30) sélectionnée, à un couvercle (2, 32) comportant des canaux (3, 4, 5) pour le passage d'eau dont les extrémités, du côté du couvercle tourné vers la cartouche, correspondent en taille et en forme avec les entrées et les sorties d'eau de la cartouche (10, 30), caractérisé en ce que entre le corps de base (1) et le couvercle (2, 32), sont disposées une bague (18) d'espacement et des parties (17, 20) de liaison pour relier les entrées et sorties d'eau (15, 16, 21, 22) dans le corps de base (1) aux canaux (3, 4, 5) de passage d'eau dans le couvercle (2, 32), le corps de base (1), la bague (18) d'espacement, les parties (17, 20) de liaison et le couvercle (2, 32) étant des parties séparées.

2. Corps de base (i) suivant la revendication 1, caractérisé en ce que le couvercle (32) porte, de son côté opposé au corps de base (1), une partie saillante (31) en forme de douille comportant un joint d'étanchéité (33) vis à vis de la cartouche (30).
